(19)

Europäisches Patentamt
European Patent Office
Office européen des brevets

(11)  **EP 1 980 601 A2**

(12)  **EUROPEAN PATENT APPLICATION**

(43) Date of publication:
**15.10.2008 Bulletin 2008/42**

(51) Int Cl.:
*C09J 7/00* (2006.01)   *C09J 7/04* (2006.01)
*C09J 11/08* (2006.01)   *C09J 133/04* (2006.01)

(21) Application number: **08006986.7**

(22) Date of filing: **08.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **09.04.2007 JP 2007101919**

(71) Applicant: **NITTO DENKO CORPORATION**
**Ibaraki-shi,**
**Osaka 567-8680 (JP)**

(72) Inventors:
• **Noritsugu, Daigaku**
**Ibaraki-shi**
**Osaka 567-8680 (JP)**

• **Takahiro, Nonaka**
**Ibaraki-shi**
**Osaka 567-8680 (JP)**
• **Masahiro, Oura**
**Ibaraki-shi**
**Osaka 567-8680 (JP)**

(74) Representative: **Grünecker, Kinkeldey,**
**Stockmair & Schwanhäusser**
**Anwaltssozietät**
**Leopoldstrasse 4**
**80802 München (DE)**

(54)  **Double-sided pressure-sensitive adhesive tape or sheet for use in wiring circuit board and wiring circuit board having the double-sided pressure-sensitive adhesive tape**

(57)     The present invention relates to a double-sided pressure-sensitive adhesive tape or sheet for use in a wiring circuit board, which includes a pressure-sensitive adhesive layer formed of a pressure-sensitive adhesive composition comprising an acrylic polymer and a tackifier resin containing a phenolic hydroxyl group; and a release liner comprising a releasing treatment layer formed of a silicone release agent. The double-sided pressure-sensitive adhesive tape or sheet of the invention has a good adhesiveness and, even after a high-temperature step, it is capable of exerting an excellent anti-repulsion property. Further, since the release liner can be easily peeled off even after the high-temperature step, the workability is excellent and the productivity is improved.

*FIG. 1*

EP 1 980 601 A2

**Description**

**FIELD OF THE INVENTION**

The present invention relates to a double-sided pressure-sensitive adhesive tape or sheet for use in a wiring circuit board and a wiring circuit board.

**BACKGROUND OF THE INVENTION**

In electronic instruments, wiring circuit boards are used and, with regard to the wiring circuit boards, flexible printed circuit boards (sometimes referred to as "FPC") have been widely used. Usually, wiring circuit boards such as FPC are used in a state of being adhered to a reinforcing plate (such as aluminum plate, stainless steel plate, or polyimide plate) and, in this case, a double-sided pressure-sensitive adhesive tape or sheet (double-sided pressure-sensitive adhesive tape or sheet for use in a wiring circuit board) is used. With regard to such a double-sided pressure-sensitive adhesive tape or sheet, a double-sided pressure-sensitive adhesive tape or sheet having a structure formed only of adhesive layers (so-called "double-sided pressure-sensitive adhesive tape or sheet without substrate") has been widely used in view of the entire thickness. However, since the double-sided pressure-sensitive adhesive tape or sheet without substrate has no substrate, it is not suitable for a fine perforating process. Moreover, there is a problem in the conventional double-sided pressure-sensitive adhesive tape or sheet that, especially under the conditions of high temperature and high humidity, the cut sides are adhered again (self-adhesion) after being perforated whereby working ability lowers. Further, in the worst case, it sometimes happens that, in detaching the perforated product, a part where an adhesive is deficient is resulted.

Although it has been attempted that, in the adhesive layer, the insoluble matter in solvent is enhanced for preventing the self-adhesion of the cut sides (refer to JP-A-2001-40301), there is a problem that, when the matter which is insoluble in a solvent is enhanced, the adhesive layer is peeled off from the adherend when the part on which repulsive force acts is adhered.

On the other hand, in wiring circuit board such as FPC, there are some cases where a high-temperature step such as a solder reflow step is conducted but, when a part on which a repulsive force is applied is adhered after the solder reflow step, a problem that the adhesive layer is peeled off from the adherend sometimes happens.

In order to solve the above-mentioned problems, the present inventors have found that when a pressure-sensitive adhesive layer formed of a pressure-sensitive adhesive composition which contains an acrylic polymer as a main ingredient and a chain transfer material is used, a double-sided pressure-sensitive adhesive tape or sheet for use in a wiring circuit board which has a good adhesiveness and is capable of providing an excellent anti-repulsion property even after a high-temperature step can be obtained.

However, the double-sided pressure-sensitive adhesive tape or sheet described above has resulted in an additional problem that, when processing is conducted while protecting the pressure-sensitive adhesive layer with a release liner and the release liner is then peeled off after the reflow step, a peel force between the liner and the pressure-sensitive adhesive layer increases and the easy releasability is lowered to thereby lower the workability and productivity.

**SUMMARY OF THE INVENTION**

In view of the above, an object of the present invention is to provide a double-sided pressure-sensitive adhesive tape or sheet for use in wiring circuit board, which has good adhesiveness and anti-repulsion property as well as excellent releasability even after a high temperature processing step such as a solder reflow step and therefore is capable of improving the productivity. Further, it also intends to provide a wiring circuit board having a double-sided pressure-sensitive tape, which employs the double-sided pressure-sensitive adhesive tape or sheet for use in the wiring circuit board.

In order to achieve the above-mentioned objects, the present inventors have made intensive investigations and found that, when a double-sided pressure-sensitive adhesive tape or sheet including a pressure-sensitive adhesive layer formed of a pressure-sensitive adhesive composition containing an acrylic polymer as a base polymer and a specific tackifier resin; and a release liner having a releasing treatment layer formed of a specific silicone release agent is used as a double-sided pressure-sensitive adhesive tape or sheet for use in a wiring circuit board, it not only has a good adhesiveness to the wiring circuit board or a reinforcing plate, exerts an excellent anti-repulsion property even after a high-temperature processing step such as a solder reflow step and is capable of maintaining a good adhesiveness even when it is used for a portion causing repulsion, but also maintains a good releasability for a release liner even after a high-temperature processing step.

Namely, the present invention provides the following (1) to (13).

(1) A double-sided pressure-sensitive adhesive tape or sheet for use in a wiring circuit board, which comprises:

> a pressure-sensitive adhesive layer formed of a pressure-sensitive adhesive composition comprising an acrylic polymer and a tackifier resin containing a phenolic hydroxyl group; and
> a release liner comprising a releasing treatment layer formed of a silicone release agent.

(2) A double-sided pressure-sensitive adhesive tape or sheet for use in a wiring circuit board, which comprises:

> a substrate;
> a plurality of pressure-sensitive adhesive layers formed on both sides of the substrate, wherein at least one of said plurality of pressure-sensitive adhesive layers is a pressure-sensitive adhesive layer formed of a pressure-sensitive adhesive composition comprising an acrylic polymer and a tackifier resin containing a phenolic hydroxyl group; and
> a release liner comprising a releasing treatment layer formed of a silicone release agent.

(3) The double-sided pressure-sensitive adhesive tape or sheet according to (1), wherein the tackfier resin containing a phenolic hydroxyl group is at least one member selected from the group consisting of a phenol-modified terpenic tackifier resin, a phenol-modified rosinic tackifier resin and a phenolic tackifier resin.

(4) The double-sided pressure-sensitive adhesive tape or sheet according to (2), wherein the tackfier resin containing a phenolic hydroxyl group is at least one member selected from the group consisting of a phenol-modified terpenic tackifier resin, a phenol-modified rosinic tackifier resin and a phenolic tackifier resin.

(5) The double-sided pressure-sensitive adhesive tape or sheet according to (1), wherein the pressure-sensitive adhesive composition contains the tackifier resin containing a phenolic hydroxyl group at a ratio of from 1 to 45 parts by weight based on 100 parts by weight of the acrylic polymer.

(6) The double-sided pressure-sensitive adhesive tape or sheet according to (2), wherein the pressure-sensitive adhesive composition contains the tackifier resin containing a phenolic hydroxyl group at a ratio of from 1 to 45 parts by weight based on 100 parts by weight of the acrylic polymer.

(7) A double-sided pressure-sensitive adhesive tape or sheet according to (2), wherein the substrate comprises a non-woven fabric.

(8) The double-sided pressure-sensitive adhesive tape or sheet according to (1), which has a thickness from one adhesive surface to the other adhesive surface of from 20 to 70 $\mu$m.

(9) The double-sided pressure-sensitive adhesive tape or sheet according to (2), which has a thickness from one adhesive surface to the other adhesive surface of from 20 to 70 $\mu$m.

(10) The double-sided pressure-sensitive adhesive tape or sheet according to (1), wherein the silicone release agent is a UV-ray curable silicone release agent.

(11) The double-sided pressure-sensitive adhesive tape or sheet according to (2), wherein the silicone release agent is a UV-ray curable silicone release agent.

(12) A wiring circuit board comprising an electric insulator layer and an electric conductor layer formed on the electric insulator layer so as to form a predetermined circuit pattern, wherein the double-sided pressure-sensitive adhesive tape or sheet according to (1) is adhered on the back side of the wiring circuit board.

(13) A wiring circuit board comprising an electric insulator layer and an electric conductor layer formed on the electric insulator layer so as to form a predetermined circuit pattern, wherein the double-sided pressure-sensitive adhesive tape or sheet according to (2) is adhered on the back side of the wiring circuit board.

Since the double-sided pressure-sensitive adhesive tape or sheet for use in a wiring circuit board according to the invention has the above-mentioned structure, it has a good adhesiveness and, even after a high-temperature step, it is capable of exerting an excellent anti-repulsion property. Further, since the release liner can be easily peeled off even after the high-temperature step, the workability is excellent and the productivity is improved.

## BRIEF DESCRIPTION OF THE DRAWINGS

Fig. 1 is a schematic cross sectional view showing an embodiment of a double-sided pressure-sensitive adhesive tape or sheet for use in wiring circuit board of the invention (embodiment of using a pressure-sensitive adhesive having no substrate and a release liner on one side thereof).

Fig. 2 is a schematic cross sectional view showing an embodiment of a double-sided pressure-sensitive adhesive tape or sheet for use in wiring circuit board of the invention (embodiment of using a pressure-sensitive adhesive having no substrate and release liners on both sides thereof).
Fig. 3 is a schematic cross sectional view showing an embodiment of a double-sided pressure-sensitive adhesive tape or sheet for use in wiring circuit board of the invention (embodiment of using a pressure-sensitive adhesive having a substrate and a release liner on one side thereof).
Fig. 4 is a schematic cross sectional view showing an embodiment of a double-sided pressure-sensitive adhesive tape or sheet for use in wiring circuit board of the invention (embodiment of using a pressure-sensitive adhesive having a substrate and release liners on both sides thereof).
Fig. 5 is a graph showing an example of a temperature profile for the heat treatment condition in a solder reflow step.

Description of Symbols

1      Double-sided pressure-sensitive adhesive tape or sheet for use in wiring circuit board
2      Adhesive portion
21     Pressure-sensitive adhesive layer
22     Substrate
3      Release liner
31     Releasing treatment layer
32     Substrate for release liner (liner substrate)
33     Back surface treatment layer

## DETAILED DESCRIPTION OF THE INVENTION

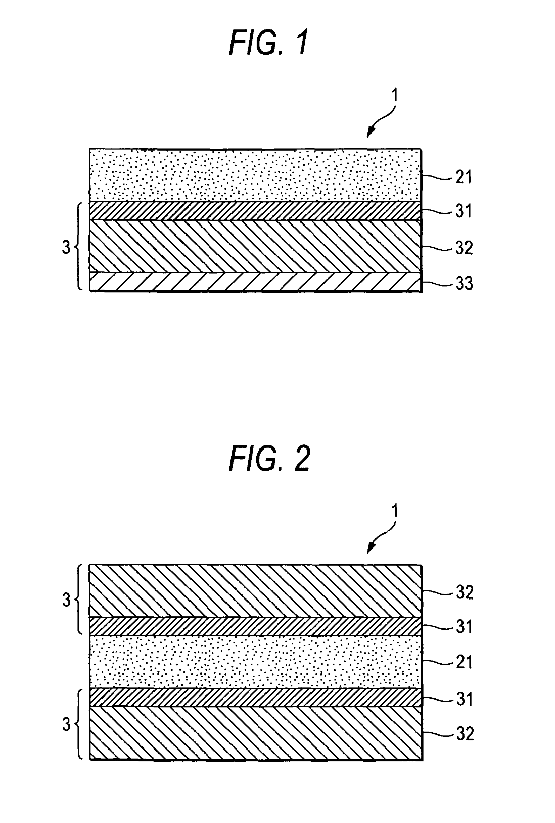

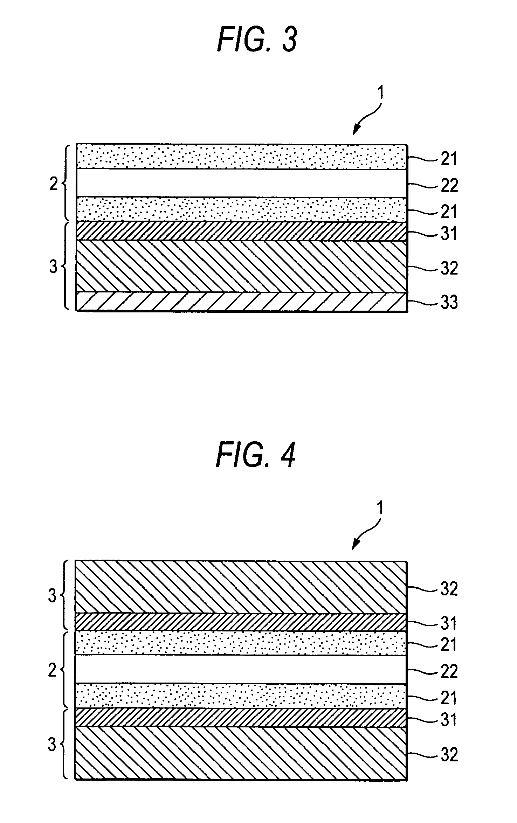

Hereinafter, embodiments of the present invention will be illustrated in more detail by referring to the drawings according to the necessity.
The double-sided pressure-sensitive adhesive tape or sheet for use in wiring circuit board of the invention includes an adhesive portion having pressure-sensitive adhesive surfaces on both sides thereof (portion other than a release liner) and the release liner. While the specific structure thereof is not particularly restricted, it includes, for example, a structure having a release liner(s) on one side or both sides of an adhesive portion (adhesive portion having no substrate) which is constituted only of a pressure-sensitive adhesive layer (refer to Fig. 1 or Fig. 2), or a structure having a release liner(s) on one side or both sides of an adhesive portion (adhesive portion having a substrate) which has pressure-sensitive adhesive layers on both sides of a substrate (refer to Fig. 3 or Fig. 4). Among all, an adhesive portion having a substrate is preferred from a standpoint of perforation workability or the like. Incidentally, in a case where a plurality of release liners are disposed on both sides of the adhesive portion, it may suffice that at least one of them is a release liner of the invention.
Figs. 1 to 4 are schematic cross sectional views showing an embodiment of a double-sided pressure-sensitive adhesive tape or sheet for use in wiring circuit board of the invention. In Figs. 1 and 2, a double-sided pressure-sensitive adhesive tape or sheet for use in wiring circuit board 1 has a release liner(s) 3 containing a releasing treatment layer 31 and a liner substrate 32 on one side or both sides of an adhesive portion (adhesive portion having no substrate) which is constituted only of pressure-sensitive adhesive layer 21. Further, in Figs. 3 and 4, a release liner(s) 3 is/are disposed on one side or both sides of an adhesive portion 2 (adhesive portion having a substrate) which has pressure-sensitive adhesive layers 21 on both sides of the substrate 22. Among them, in the case that a release liner is disposed only on one side of the tape or sheet (Figs. 1 and 3), a back side treatment layer 33 containing a release agent is preferably disposed on the side of the release liner 3 which is opposite to the side on which the releasing treatment layer 31 is disposed.

Pressure-sensitive adhesive layer

The pressure-sensitive adhesive layer of the invention is formed of a pressure-sensitive adhesive composition containing an acrylic polymer as a main ingredient and a tackifier resin containing a phenolic hydroxyl group. Such a pressure-sensitive adhesive composition can be prepared by mixing an acrylic polymer, a tackifier resin containing a phenolic hydroxyl group and optional various kinds of additives.

Tackifier resin

The pressure-sensitive adhesive composition forming the pressure-sensitive layer of the invention contains a tackifier resin containing a phenolic hydroxyl group (hydroxyl group which directly binds to a carbon atom constituting an aromatic ring). As the tackifier resin containing a phenolic hydroxyl group (hydroxyl group-containing aromatic ring), a phenol-modified terpenic tackifier resin (terpene-phenol tackifier resin), phenol-modified rosinic tackifier resin (rosin-phenolic tackifier resin), and phenolic tackifier resin are suitable. The tackifier resin containing a phenolic hydroxyl group can be used alone or two or more in combination.

In the tackifier resin containing a phenolic hydroxyl group, examples of the phenol-modified terpeneic tackifier resin include phenol-modified terpeneic resins (terpene-phenol-based resins) where various kinds of terpenic resins (such as an α-pinene polymer, a β-pinene polymer and a dipentene polymer) are modified by phenol.

Examples of the phenol-modified rosinic tackifier resin include phenol-modified rosinic resins (rosin-modified phenol resins) where phenol is added to various kinds of rosins (such as non-modified rosin, modified rosin and various kinds of rosin derivatives) using an acid catalyst followed by subjecting to a thermal polymerization so that the various kinds of rosins are subjected to modification with phenol.

Further, examples of the phenolic tackifier resin include condensates of various kinds of phenols such as phenol, resorcinol, cresols (including m-cresol and p-cresol), xylenols (including 3,5-xylenol) and alkylphenols including p-isopropylphenol, p-tertbutylphenol, p-amylphenol, p-octylphenol, p-nonylphenol and p-dodecylphenol (particularly, p-alkylphenols) with formaldehyde (such as alkylphenol resin, phenol formaldehyde resin and xylene formaldehyde resin) as well as resol where the above-mentioned phenols are subjected to an addition polymerization with formaldehyde using an alkali catalyst, novolak where the above-mentioned phenols are subjected to a condensation reaction with formaldehyde using an acid catalyst, etc. Although the number of carbon atom(s) of the alkyl group in the alkylphenols is not particularly limited, it may be appropriately selected from the range of 1 to 18. Preferred examples of the phenolic tackifier resin include alkylphenol resin and xylene formaldehyde resin and, among them, alkylphenol resin is particularly preferred.

Among them, as the tackifier resin containing a phenolic hydroxyl group of the invention, alkylphenol resin, rosin-modified phenolic resin, and terpene-phenol-based resin are particularly preferred and the terpene-phenol-based resin is most preferred.

The softening point of the tackifier resin containing a phenolic hydroxyl group of the invention is preferably 60°C or higher and, particularly preferably, 100°C or higher from a view point of heat resistance or the like.

Although the use amount of the tackifier resin containing a phenolic hydroxyl group of the invention is not particularly restricted, it can be properly selected, for example, from a range of 1 to 45 parts by weight based on 100 parts by weight of the acrylic polymer in the pressure-sensitive adhesive composition. From a standpoint of the effect for improving the releasability after high-temperature step, it is preferably from 7 to 23 parts by weight and, more preferably, from 10 to 20 parts by weight. When the use amount is less than 1 part by weight, adhesion after a high-temperature processing step such as a solder reflow step may be lowered or easy releasability from the release liner cannot be obtained in some cases. On the other hand, when it exceeds 45 parts by weight, tackiness of the pressure-sensitive adhesive composition is lowered to lower the adhesiveness or pressure-sensitive adhesiveness in some cases.

The tackifier resin containing a phenolic hydroxyl group according to the invention plays a role of catching radicals as well as providing a pressure-sensitive adhesiveness to the pressure-sensitive adhesive layer thereby improving the adhesiveness. Accordingly, even when the radicals are generated in the acrylic polymer during a high-temperature step such as a solder reflow step, the radicals can be inactivated effectively. Accordingly, degradation (gelation) of the acrylic polymer can be inhibited and the pressure-sensitive adhesive layer can maintain good adhesiveness even after the high-temperature step.

Further, by adding the tackifier resin containing a phenolic hydroxyl group according to the invention, it is possible to maintain good releasability from the release liner even after the high-temperature step. This is assumed that since the tackifier resin containing a phenolic hydroxyl group has a property of evaporating under a high temperature to be readily precipitated on the surface of the pressure-sensitive adhesive layer, the silicone ingredient contained in the releasing treatment layer of the release liner and acrylic acid of the acrylic polymer are bonded under heating to prevent the decrease of the releasability.

Acrylic polymer

The pressure-sensitive adhesive composition forming the pressure-sensitive adhesive layer of the invention contains an acrylic polymer as a main ingredient. The acrylic polymer plays a role of developing tackiness as a base polymer of the pressure-sensitive adhesive layer. The content of the acrylic polymer as a main ingredient in the pressure-sensitive adhesive composition is 60% by weight or more, preferably 79% by weight or more (for example, 79 to 93% by weight), and more preferably, 83% by weight or more.

As the acrylic polymer, a (meth)acrylate ester polymer containing a (meth)acrylate ester (acrylate ester and/or methacrylate ester) as a main monomer ingredient can be used. Examples of the (meth)acrylate ester include the following alkyl (meth)acrylate ester, as well as cycloalkyl (meth)acrylate ester such as cyclohexyl (meth)acrylate ester, and an aryl (meth)acrylate ester such as phenyl (meth)acrylate ester. As the (meth)acrylate ester, an alkyl (meth)acrylate ester can be preferably used. That is, as the acrylic polymer, an alkyl (meth)acrylate ester polymer containing an alkyl (meth)acrylate ester as a main monomer ingredient can be preferably used. The (meth)acrylate ester can be used alone or two or more in combination.

Examples of the alkyl (meth)acrylate used as a main monomer component in the acrylic polymer include methyl (meth)acrylate, ethyl (meth)acrylate, propyl (meth)acrylate, isopropyl (meth)acrylate, n-butyl (meth)acrylate, isobutyl (meth)acrylate, sec-butyl (meth)acrylate, tert-butyl (meth)acrylate, pentyl (meth)acrylate, isopentyl (meth)acrylate, neopentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth) acrylate, hexadecyl (meth)acrylate, heptadecyl (meth)acrylate, octadecyl (meth)acrylate, nonadecyl (meth)acrylate and eicosyl (meth)acrylate.

With regard to the (meth)acrylate such as an alkyl (meth)acrylate in the acrylic polymer, since it is used as a main monomer component, it is important that the proportion thereof with respect to the total amount of monomer components is 50% by weight or more, preferably 80% by weight or more and, more preferably, 90% by weight or more. Although the upper limit of the (meth)acrylate with respect to the total amount of the monomer components is not particularly limited, it is preferably 99% by weight or less(preferably 98% by weight or less and, more preferably, 97% by weight or less). When the proportion of the (meth)acrylate with respect to the total amount of the monomer components is less than 50% by weight, there are some cases where characteristics as an acrylic polymer (such as adhesive property) are hardly exerted.

In the acrylic polymer, it is possible that a monomer component which is capable of being copolymerized with the (meth)acrylate (copolymerizing monomer) is used as a monomer component. The copolymerizing monomer may be used for introduction of a cross-linking point into the acrylic polymer or for control of cohesive force of the acrylic polymer. Each copolymerizing polymer may be used solely or two or more thereof may be used in combination.

To be more specific, as the copolymerizing monomer, it is possible to use a monomer component containing a functional monomer (particularly, a monomer component containing a thermal cross-linking functional group for introduction of cross-linking point which can be subjected to a thermal cross-linking to an acrylic polymer] for introduction of a cross-linking point into an acrylic polymer. With regard to such a monomer containing a functional group, there is no particular limitation so long as it is a monomer component which is capable of being copolymerized with an alkyl (meth) acrylate and has a functional group which can be a cross-linking point and examples thereof include a monomer containing a carboxyl group such as (meth)acrylic acid, itaconic acid, crotonic acid, maleic acid, fumaric acid and isocrotonic acid or an acid anhydride thereof (such as maleic anhydride and itaconic anhydride); a hydroxyalkyl (meth)acrylate such as 2-hydroxyethyl (meth)acrylate, 2-hydroxypropyl (meth)acrylate and 2-hydroxybutyl (meth)acrylate; and, in addition, a monomer containing a hydroxyl group such as vinyl alcohol and allyl alcohol; an amide-type monomer such as (meth) acrylamide, N,N-dimethyl(meth)acrylamide, N-butyl (meth)acrylamide, N-methylol (meth)acrylamide, N-methylolpropane (meth)acrylamide, N-methoxymethyl (meth)acrylamide and N-butoxymethyl (meth)acrylamide; a monomer containing an amino group such as aminoethyl (meth)acrylate, N,N-dimethylethyl (meth)acrylate and tert-butylaminoethyl (meth)acrylate; a monomer containing an epoxy group such as glycidyl (meth)acrylate and methylglycidyl (meth)acrylate; a cyano-containing monomer such as acrylonitrile and methacrylonitrile; and a monomer having a nitrogen-containing ring such as N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam and N-(meth)acryloylmorpholine. As the monomer component containing a functional group, a monomer containing a carboxyl group such as acrylic acid or an acid anhydride thereof may be advantageously used.

As a copolymerizing monomer, it is also possible to use other copolymerizing monomer component in order to control the cohesive force of the acrylic polymer. Examples of other copolymerizing monomer component as such include a monomer of a vinyl ester type such as vinyl acetate and vinyl propionate; a monomer of a styrene type such as styrene, substituted styrene (e.g., α-methylstyrene) and vinyltoluene; a monomer of an olefin type such as ethylene, propylene, isoprene, butadiene and isobutylene; vinyl chloride and vinylidene chloride; a monomer containing an isocyanate group such as 2-(meth)acryloyloxyethyl isocyanate; a monomer containing an alkoxy group such as methoxyethyl (meth)acrylate and ethoxyethyl (meth)acrylate; a monomer of a vinyl ether type such as methyl vinyl ether and ethyl vinyl ether; and a multifunctional monomer such as 1,6-hexanediol di(meth)acrylate, ethylene glycol di(meth)acrylate, diethylene glycol di(meth)acrylate, triethylene glycol di(meth)acrylate, tetraethylene glycol di(meth)acrylate, (poly)ethylene glycol di(meth)acrylate, propylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, glycerol di(meth)acrylate, epoxyacrylate, polyester acrylate, urethane acrylate, divinylbenzene, butyl di(meth)acrylate and hexyl di(meth)acrylate.

As the copolymerizing monomer in an acrylic polymer, a monomer containing a carboxyl group is preferred and, in view of heat resistance, acrylic acid may be used particularly preferably.

In the acrylic polymer, the proportion of the copolymerizing monomer may be appropriately selected within a range of less than 50% by weight with respect to the total amount of the monomer components depending upon the type of the monomer components. For example, when the copolymerizing monomer is a monomer containing a carboxyl group (particularly, acrylic acid), it is adequate that the monomer containing a carboxylic acid (particularly, acrylic acid) is 3 to 10 parts by weight (preferably 5 to 10 parts by weight and, more preferably, 7 to 10 parts by weight) with respect to 100 parts by weight of the total monomer components.

The acrylic polymer can be prepared by a conventional or common polymerization method. Examples of the polymerization method for the acrylic polymer include a solution polymerization method, an emulsion polymerization method, a bulk polymerization method and a polymerization method by irradiation of ultraviolet ray. In the polymerization of the acrylic polymer, an appropriate component which is suitable for each polymerization method such as polymerization initiator, chain transfer agent, emulsifier and solvent may be appropriately selected from conventional or common ones and may be employed.

In order to enhance the retaining characteristic of the pressure-sensitive adhesive layer, the acrylic polymer may have a cross-linking structure using a cross-linking agent or the above-mentioned multifunctional monomer as a copolymerizing monomer component. By adjusting the amount of the cross-linking agent or the multifunctional monomer used, a gel fraction (the rate of a matter which is insoluble in a solvent) in the pressure-sensitive adhesive layer may be controlled.

Besides a cross-linking agent of an isocyanate type, a cross-linking agent of an epoxy type, a cross-linking agent of a melamine type and a cross-linking agent of a peroxide type, examples of the cross-linking agent which are further listed include a cross-linking agent of a urea type, a cross-linking agent of a metal alkoxide type, a cross-linking agent of a metal chelate type, a cross-linking agent of a metal salt type, a cross-linking agent of a carbodiimide type, a cross-linking agent of an oxazoline type, a cross-linking agent of an aziridine type and a cross-linking agent of an amine type and, among them, a cross-linking agent of an isocyanate type and a cross-linking agent of an epoxy type may be advantageously used. Each of those cross-linking agents may be used solely or two or more thereof may be used in combination.

In the cross-linking agent, examples of the cross-linking agent of an isocyanate type include lower aliphatic polyisocyanates such as 1,2-ethylene diisocyanate, 1,4-butylene diisocyanate and 1,6-hexamethylene diisocyanate; alicyclic polyisocynates such as cyclopentylene diisocyanate, cyclohexylene diisocyanate, isophorone diisocyanate, hydrogenated tolylene diisocyanate and hydrogenated xylene diisocyanate; and aromatic polyisocyanates such as 2,4-tolylene diisocyanate, 2,6-tolylene diisocyanate, 4,4'-diphenylmethane diisocyanate and xylylene diisocyanate. Besides those, it is also possible to use an adduct of trimethylolpropane/tolylene diisocyanate trimer (manufactured by Nippon Polyurethane Industry Co., Ltd.; trade name: "Coronate L"), an adduct of trimethylolpropane/hexamethylene diisocyanate trimer (manufactured by Nippon Polyurethane Industry Co., Ltd.; trade name: "Coronate HL"), and the like.

Examples of the cross-linking agent of an epoxy type include N,N,N',N'-tetraglycidyl m-xylenediamine, diglycidyl aniline, 1,3-bis(N,N-glycidylaminomethyl)-cyclohexane, 1,6-hexanediol diglycidyl ether, neopentyl glycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcinol diglycdl ether and bisphenol S-diglycidyl ether and, besides them, resins of an epoxy type having two or more epoxy groups in the molecule thereof may be also mentioned.

Instead of the use of a cross-linking agent in the present invention, it is also possible to form a pressure-sensitive adhesive layer by subjecting to a cross-linking treatment by means of irradiation of electronic ray, ultraviolet ray, and the like, together with the use of a cross-linking agent.

Weight-average molecular weight of the acrylic polymer may be appropriately selected from the range of, for example, 700,000 to 2,000,000 (preferably 800,000 to 1,700,000 or, more preferably, 900,000 to 1,400,000). When the weight-average molecular weight of the acrylic polymer is less than 700,000, there may be the case where no good adhesive characteristic is achieved while, when it is more than 2,000,000, there may be the case where problem is resulted in an applying property whereby any of them is not preferred.

The weight-average molecular weight of the acrylic polymer can be controlled by the type and the use amount of a polymerization initiator and a chain transfer agent, the temperature and the time for the polymerization and, further, by the concentration of the monomer, dropping speed of the monomer, and the like. In the present invention, the weight-average molecular weight of the acrylic polymer was measured, for example, under the following measuring conditions.

Name of the apparatus used: "HLC-8120 GPC" manufactured by Tosho Corporation
Column: "TSK gel Super HZM-H/HZ4000/HZ3000/HZ2000" (manufactured by Tosoh Corporation)
Inlet pressure: 7.2 MPa
Column size: each 6.0 mm Ø × 15 cm; 60 cm in total
Column temperature: 40°C

Eluting liquid: tetrahydrofuran (THF)
Flow rate: flowing speed 0.6 mL/min
Sample concentration: 0.1% by weight (a solution in tetrahydrofuran)
Infusing amount of sample: 20 $\mu$L
Detector: differential refractometer (RI)
Standard sample: polystyrene (PS)
Data processing apparatus: "GPC-8020" manufactured by Tosoh Corporation

Other additives

The pressure-sensitive adhesive composition of the invention may be optionally incorporated, in addition to the ingredients described above, with conventional additives such as deterioration inhibitor, filler, colorant (pigment or dye), UV absorbent, antioxidant, tackifier, plasticizer, softener, cross-linker, surfactant, and antistatic agent within a range not impairing the performance of the invention.

Pressure-sensitive adhesive layer

There is no particular limitation for the method of forming a pressure-sensitive adhesive layer of the invention but the method may be appropriately selected from the conventional method for the formation of a pressure-sensitive adhesive layer. Specific examples of the method for the formation of a pressure-sensitive adhesive layer include a method where a pressure-sensitive adhesive composition is applied on a surface (such as a substrate) whereby the thickness after drying becomes a predetermined thickness and then optionally dried or hardened, and a method where a pressure-sensitive adhesive composition is applied on an appropriate separator (such as a release paper) whereby the thickness after drying becomes a predetermined thickness and then optionally dried or hardened and the resulting adhesive layer is transcribed (transferred) onto a predetermined surface (such as a substrate). In applying the pressure-sensitive adhesive composition, commonly used applying devices (such as a gravure roll coater, a reverse roll coater, a kiss roll coater, a dip roll coater, a bar coater, a knife coater and a spray coater) may be used.

Although the thickness of the pressure-sensitive adhesive layer of the invention is not particularly limited, it may be appropriately selected from the range of, for example, 10 to 70 $\mu$m (preferably 15 to 60 $\mu$m and, more preferably, 20 to 50 $\mu$m). When the thickness of a pressure-sensitive adhesive layer is less than 10 $\mu$m, there is a tendency that good adhesiveness cannot be achieved while, when it is more than 70 $\mu$m, there are some cases where the product is not suitable for the use in a wiring circuit board. Incidentally, the pressure-sensitive adhesive layer may be in any of forms of single layer and plural layers.

In the pressure-sensitive adhesive layer of the invention, the gel fraction before a solder reflow step conducted under the following heat treatment conditions (hereinafter referred to as "gel fraction in the initial stage") is preferably from 40 to 70% by weight (more preferably 50 to 70% by weight, and still more preferably 55 to 65% by weight), and the difference between the gel fraction (wt%) after the solder reflow step (hereinafter referred to as "gel fraction after reflow step") and the gel fraction (wt%) in the initial stage is preferably 10 or less (more preferably 7 or less, still more preferably 5 or less, further preferably 3 or less, still further preferably 1 or less, and most preferably 0). When the gel fraction in the initial stage of the pressure-sensitive adhesive layer is less than 40% by weight, the retaining property of the pressure-sensitive adhesive layer may be lowered in some cases. On the other hand, when it exceeds 70% by weight, the anti-repulsion property of the pressure-sensitive adhesive layer may be lowered in some cases. Furthermore, it is preferable that the difference between the gel fraction (wt%) after the reflow step and the gel fraction in the initial stage (wt%) is 10 or less, since the gel fraction does not increase excessively even after a high temperature step such as a solder reflow step and an excellent anti-repulsion property can be exerted in this case.

Heat treatment condition in solder reflow step

(1) The surface temperature of the double-sided pressure-sensitive adhesive tape or sheet (or the pressure-sensitive adhesive layer) reaches 175 $\pm$ 10°C (165 to 185°C) within 130 to 180 seconds after start of the solder reflow step for the double-sided pressure-sensitive adhesive tape or sheet (or the pressure-sensitive adhesive layer).
(2) The surface temperature of the double-sided pressure-sensitive adhesive tape or sheet (or the pressure-sensitive adhesive layer) reaches 230 $\pm$ 10°C (220 to 240°C) within 200 to 250 seconds after start of the solder reflow step for the double-sided pressure-sensitive adhesive tape or sheet (or the pressure-sensitive adhesive layer).
(3) The surface temperature of the double-sided pressure-sensitive adhesive tape or sheet (or the pressure-sensitive adhesive layer) reaches 255 $\pm$ 15°C (240 to 270°C) within 260 to 300 seconds after start of the solder reflow step for the double-sided pressure-sensitive adhesive tape or sheet (or the pressure-sensitive adhesive layer).
(4) The solder reflow step finishes within 370 seconds after start of the solder reflow step for the double-sided pressure-sensitive adhesive tape or sheet (or the pressure-sensitive adhesive layer).

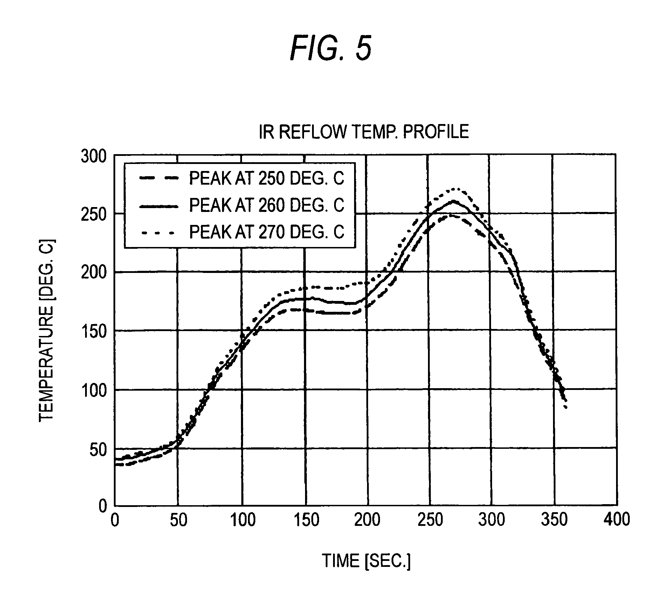

The solder reflow step described above is not particularly restricted so long as it satisfies the heat treatment conditions described above and includes, for example, a solder reflow step based on the heat treatment condition according to a temperature profile as shown by the graph in Fig. 5. In Fig. 5, an ordinate is temperature (°C, degree Celsius) and an abscissa is time (second(s)). In Fig. 5, temperature profiles of three examples where the peak temperature or the highest temperature is about 250°C, about 260°C and about 270°C are shown. In the present invention, the surface temperature of the double-sided pressure-sensitive adhesive tape or sheet (or the pressure-sensitive adhesive layer) in the solder reflow step is continuously measured by a temperature sensor after a thermocouple is fixed on the surface of the double-sided pressure-sensitive adhesive tape or sheet (or pressure-sensitive adhesive layer) using a pressure-sensitive adhesive tape (a heat-resistant pressure-sensitive adhesive tape including a polyimide film as a substrate). Incidentally, in the solder reflow step, the following solder reflow instrument is used while, in the measurement of the surface temperature, the following temperature sensor is used.

Solder reflow instrument: Conveyer-type heating apparatus by far-infrared and hot wind (manufactured by Noritake Co., Ltd.)
Temperature sensor: Keyence NR-250 (manufactured by Keyence Corporation)

The gel fraction (rate of solvent insoluble matter) is a value calculated by the following "Method for measurement of gel fraction".

Method for measurement of gel fraction

After a pressure-sensitive adhesive composition is applied on a release liner, it is dried or hardened to form a pressure-sensitive adhesive layer. About 0.1 g of the pressure-sensitive adhesive layer or the pressure-sensitive adhesive layer after a solder reflow step satisfying the above-mentioned heat treatment conditions is packed with a tetrafluoroethylene sheet having a thickness of 0.2 μm (trade name: "NTF 1122"; manufactured by Nitto Denko Corporation) and tied up with a kite string and the weight at that time is measured and used as a weight before dipping. Incidentally, the weight before dipping is a total weight covering the weights of the pressure-sensitive adhesive layer, the tetrafluoroethylene sheet and the kite string. Further, the weight of the tetrafluoroethylene sheet and the kite string is measured and the weight is defined as a package weight.
After that, the product where the pressure-sensitive adhesive layer is wrapped with the tetrafluoroethylene sheet followed by being bound up with the kite string is placed in a 50-ml container filled with ethyl acetate and allowed to stand at room temperature for one week (seven days). Then, the tetrafluoroethylene sheet is taken out from the container, transferred to a cup made of aluminum and dried in a drier at 130°C for 2 hours to remove ethyl acetate, then the weight of the sample is measured and the weight is defined as a weight after dipping.
Now a gel fraction is calculated by the following formula.

$$\text{Gel Fraction (\% by weight)} = (A - B)/(C - B) \times 100 \qquad (1)$$

(In the formula (1), A is weight after dipping, B is package weight and C is weight before dipping.)

Adhesive portion

According to the invention, the adhesive portion used in the double-sided pressure-sensitive adhesive tape or sheet for use in wiring circuit board may have a constitution which includes no substrate and is constituted only of a pressure-sensitive adhesive layer (adhesive portion having no substrate), or a constitution in which pressure-sensitive adhesive layers are formed on both sides of a substrate (adhesive portion having a substrate). Particularly, the adhesive portion having a substrate is preferred from a standpoint of improving the perforation workability. In this regard, in a case that the adhesive portion is an adhesive portion having a substrate, although at least one of the pressure-sensitive adhesive layers formed on both sides of the substrate may be the pressure-sensitive adhesive layer according to the invention, it is preferable that the pressure-sensitive adhesive layers according to the invention are formed on both sides of the substrate.
The adhesive portion of the invention may optionally have other layers (such as an intermediate layer and an undercoated layer) within such an extent that the advantages of the present invention are not deteriorated by them.

Substrate

In the case that the adhesive portion of the invention is an adhesive portion having a substrate, a substrate having a heat resistance is preferred and it is possible to use an appropriate thin leafy substance, for example, a fibrous substrate such as cloth, nonwoven fabric, felt and net; a paper substrate such as various types of paper; a metal substrate such as metal foil and metal plate; a plastic substrate such as film or sheet of various kinds of resins (e.g., olefin resin, polyester resin, polyvinyl chloride resin, vinyl acetate resin, amide resin, polyimide resin, polyether ether ketone and polyphenylene sulfide); a foamed product such as foamed sheet; and a layered product thereof. The substrate may be in a form of single layer or may have a form of plural layers.
In view of heat resistance, anchoring property of a pressure-sensitive adhesive, cost, etc. a fibrous substrate is preferred as the substrate in the invention and, particularly, non-woven fabrics made of natural fibers can be used suitably and, among them, non-woven fabric containing manila hemp is particularly preferred.
The thickness of the substrate can be properly determined depending on the use and, in general, it is, for example, from 5 to 40 $\mu$m (preferably, 10 to 30 $\mu$m and, more preferably, 10 to 20 $\mu$m).
When the substrate is nonwoven fabric, although there is no particular limitation for the package weight of the nonwoven fabric, it is preferably 5 to 15 g/m$^2$ and, particularly preferably, 6 to 10 g/m$^2$. When the package weight of nonwoven fabric is less than 5 g/m$^2$, the strength lowers while, when it is more than 15 g/m$^2$, it is difficult to fulfill the required thickness.
The strength of the substrate is, preferably, 2 (N/15 mm) or more and, more preferably, 5 (N/15 mm) or more in an MD direction (longitudinal direction or machine direction).
The surface of the substrate may be optionally applied with a customary surface treatment, for example, an oxidation treatment by a chemical or physical method such as by means of chromic acid treatment, exposure to ozone, exposure to flame, exposure to high-voltage electric shock, and treatment with ionizing radiation rays for enhancing the close adhesion with the pressure-sensitive adhesive layer. A coating treatment by an undercoating agent may be applied as well.
In a case of an adhesive portion having a substrate, the adhesive portion of the invention can be manufactured by forming a pressure-sensitive adhesive layer on each of the surfaces of the substrate optionally through an other layer, in accordance with methods of forming a pressure-sensitive adhesive layer exemplified above. On the other hand, in a case of an adhesive portion having no substrate, it can be manufactured by forming a pressure-sensitive adhesive layer on a release liner optionally through an other layer.

Release liner

In the double-sided pressure-sensitive adhesive tape or sheet for use in wiring circuit board of the invention, the surface of the pressure-sensitive adhesive layer (adhesive surface) is protected by a release liner (separator). In the double-sided pressure-sensitive adhesive tape or sheet for use in wiring circuit board, each of the adhesive surfaces may be respectively protected by two release liners, or they may also be protected by one release liner having release surfaces on both sides thereof while the pressure-sensitive adhesive tape or sheet is wounded into a roll form.
The release liner employed in the double-sided pressure-sensitive adhesive tape or sheet for use in wiring circuit board of the invention has a releasing treatment layer formed of a silicone release agent on a substrate (liner substrate) such as of glassine paper.
As the silicone release agent forming the releasing treatment layer of the release liner of the invention, an ionizing radiation-curable silicone release agent or a thermosetting silicone release agent can be used. Since the ionizing radiation-curable silicone release agent such as a UV-ray curable silicone release agent generates no thermal radical, it is preferable in view of the peeling strength after a high temperature treatment. The thermosetting silicone release agent such as a thermal addition reaction type silicone release agent is advantageous in view of the cost. Among them, the UV-ray curable silicone release agent is most preferred from a standpoint of the peeling strength after a high temperature treatment.

Ionizing radiation curable silicone release agent

The ionizing radiation curable silicone release agent used as the silicone release agent of the invention is not particularly restricted so long as it is a silicone release agent that is cured by an ionizing radiation (such as $\alpha$-rays, $\beta$-rays, $\gamma$-rays, neutron rays, electron beams, and UV-ray), and the UV-ray curable silicone release agent that is cured by crosslinking (curing reaction) under the irradiation of UV-rays to form a releasable film can be preferably used. The ionizing radiation curable silicone release agent can be used alone or two or more in combination.

The UV-curable silicone release agent is not particularly restricted so long as it is a silicone release agent capable of being cured under the irradiation of UV-rays, and agents of various kinds of curing type (curing mechanism) can be used. Examples of curing type includes a cation polymerization type cured by cation polymerization, a radical polymerization type cured by radical polymerization, a radical addition type cured by radical addition polymerization, and a hydrosilylation reaction type cured by hydrosilylating reaction. As the curing type of the UV-ray curable silicone release agent, the cation polymerization type is particularly preferred. That is, as the UV-ray curable silicone release agent, the cationically polymerizable UV-ray curable silicone release agent is preferably used.

In the cationically polymerizable UV-ray curable silicone release agent, an epoxy functional silicone polymer ingredient in which one or more epoxy functional organic groups are introduced to the polysiloxane ingredient in the main chain is used alone or two or more in combination. The epoxy functional organic group may be bonded directly or bonded through a bivalent group (for example, a bivalent organic group such as an alkylene group or alkyleneoxy group) to the silicone atom in the main chain or the side chain of the polysiloxane ingredient. It is important that at least two epoxy functional organic groups are introduced in the polysiloxane ingredient of the main chain.

In the cationically polymerizable LTV-ray curable silicone release agent, specific examples of the epoxy functional organic group include glycidyl group, glycidoxy group (glycidyloxy group), 3,4-epoxycyclohexyl group and 2,3-epoxycyclopentyl group.

The epoxy functional silicone polymer ingredient can be obtained, for example, by addition reaction of an olefinic epoxy monomer such as 4-vinyl cyclohexene oxide, allylglycidyl ether or 7-epoxy-1-octentene to polymethyl hydrogen siloxane as a base polymer using a catalyst such as a platinum compound. The epoxy functional silicone polymer ingredient may have either a linear or branched chained form, or may be a mixture of them.

Further, for the cationically polymerizable UV-ray curable silicone release agent, an onium salt UV-ray fragmentation initiator (onium salt photopolymerization initiator) can be used as the UV-ray fragmentation initiator (photopolymerization initiator). The onium salt UV-ray fragmentation initiator can be used alone or two or more in combination.

Examples of the onium salt UV-ray fragmentation initiator includes an onium salt photoinitiator described in JP-A-6-32873, an onium salt photoinitiator described in JP-A-2000-281965, an onium salt photoinitiator described in JP-A-11-228702, and an onium salt photoinitiator described in JP-B-8-26120. Examples of such onium salt UV-ray fragmentation initiator include diaryl iodonium salt, triarylsulfonium salt, triarylselenonium salt, tetraaryl phosphonium salt, and aryl diazonium salt. As the onium salt UV-ray fragmentation initiator, diaryl iodonium salt is preferred.

More specifically, examples of the diaryl iodonium salt include a compound represented by "$Y_2I^+X^-$" (in which Y represents an aryl group which may have a substituent, and $X^-$ represents a non-nucleophilic and non-basic anion). Further, examples of the non-nucleophilic and non-basic anion X' include $SbF_6^-$, $SbCl_6^-$, $BF_4^-$, $[B(C_6H_5)_4]^-$, $[B(C_6F_5)_4]^-$, $[B(C_6H_4CF_3)_4]^-$, $[(C_6F_5)_2BF_2]^-$, $[C_6F_5BF_3]^-$, $[B(C_6H_3F_2)_4]^-$, $AsF_6^-$, $PF_6^-$, $HSO_4^-$, and $ClO_4^-$. As the anions described above, antimony type anions and boron type anions are suitable.

Examples of the tiarylsulfonium salt, triarylselenonium salt, tetraarylphosphonium salt, and aryldiazonium salt include compounds corresponding to the diaryl iodonium salts described above. Specifically, for the triarylsulfonium salt, triaryl selenonium salt, tetraaryl phosphonium salt, and aryldiazonium salt, those compounds represented by "$Y_3S^+X$", "$Y_3Se^+X$" "$Y_4P^+)C$", and "$YN_2^+X^-$" (in which Y and $X^-$ have the same meanings as described above) can be used.

As the onium salt UV-ray fragmentation initiator, a UV-ray fragmentation initiator containing an antimony atom (antimony type UV-ray fragmentation initiator), and a UV-ray fragmentation initiator containing a boron atom (boron type UV-ray fragmentation initiator) can be preferably used, and a diaryl iodonium salt UV-ray fragmentation initiator containing the antimony atom or a diaryl iodonium salt UV-ray fragmentation initiator containing the boron atom is particularly suitable.

Accordingly, examples of the cationically polymerizable UV-ray curable silicone release agent include those containing at least a polysiloxane ingredient having at least two epoxy functional organic groups in the molecule (epoxy functional silicone polymer ingredient) and an onium salt UV-ray fragmentation initiator. In the cationically polymerizable UV-ray curable silicone release agent, the ratio of the onium salt UV-ray fragmentation initiator is not particularly restricted so long as it is used in a catalytic amount and it can be selected, for example, within a range from 0.1 to 8 parts by weight, preferably from 0.3 to 5 parts by weight, and more preferably from 0.5 to 3 parts by weight, based on 100 parts by weight of the epoxy functional silicone polymer ingredient.

The cationically polymerizable UV-ray curable silicone release agent can be prepared by mixing the constituent ingredients described above (epoxy functional silicone polymer ingredient, and optional onium salt UV-ray fragmentation initiator and various kinds of additives) with optionally using an organic solvent. The cationically polymerizable UV-ray curable silicone release agent can be used in a state where the polymer ingredient such as the epoxy functional silicone polymer ingredient is dissolved in the organic solvent. The cationically polymerizable UV-ray curable silicone release agent may be properly blended with known or customary additives such as filler, antistatic, antioxidant, plasticizer, and colorant (dye or pigment).

As the cationically polymerizable UV-ray curable silicone release agent, for example, "X-62-7622" (trade name, manufactured by Shin-Etsu Chemical Co.); "X-62-7629" (trade name, manufactured by Shin-Etsu Chemical Co.); "X-62-7655" (trade name, manufactured by Shin-Etsu Chemical Co.); "X-62-7634" (trade name, manufactured by Shin-Etsu Chemical Co.); and "X-62-7658" (trade name, manufactured by Shin-Etsu Chemical Co., Ltd.), etc. are commercially available.

Thermosetting silicone release agent

Thermosetting silicone release agent used as the silicone release agent of the invention is not particularly restricted so long as it is a silicone release agent cured by heat, and a thermal addition reaction type silicone release agent that is cured by thermal addition reaction type crosslinking (curing reaction) to form a releasable film can be preferably used. The thermosetting silicone release agent can be used alone or two or more in combination.

For the thermal addition reaction type silicone release agent, a thermal addition reaction type polysiloxane release agent which contains a polysiloxane polymer having a group reactive to a group containing an Si-H bond in the molecule thereof, and a polysiloxane polymer having an hydrogen atom bonded to a silicon atom in the molecule thereof can be used. Herein, "Si-H bond" means "bond between silicon atom (Si) and hydrogen atom (H)".

In the polysiloxane polymer having a group reactive to a group containing an Si-H bond in the molecule thereof, examples of the group reactive to a group containing an Si-H bond include an alkenyl group such as a vinyl group or a hexenyl group. It is preferred that two or more alkenyl groups are present in the molecule of a polysiloxane polymer having a group reactive to a group containing an Si-H bond in the molecule thereof. Further, in the polysiloxane polymer having a hydrogen atom bonded to a silicon atom in the molecule thereof, it is preferred that two or more hydrogen atoms bonded to silicon atoms are present in the molecule thereof. Accordingly, as the thermal addition reaction type silicone release agent, a polysiloxane release agent containing a polysiloxane polymer having two or more alkenyl groups in the molecule thereof and a polysiloxane polymer having two or more hydrogen atoms bonded to silicon atoms in the molecule thereof is suitable.

In the polysiloxane polymer having two or more alkenyl groups in the molecule thereof, alkenyl groups are usually bonded directly to silicone atoms of the polysiloxane polymer forming the main chain or skeleton (for example, a silicone atom at the terminal end or a silicone atom in the inside of the main chain). Accordingly, as the polysiloxane polymer having two or more alkenyl groups in the molecule thereof, a polysiloxane polymer having two or more alkenyl groups bonding directly to silicon atoms in the molecule thereof can be suitably used. Examples of the polysiloxane polymer forming the main chain or the skeleton include a polyalkyl alkyl siloxane polymer such as polydimethyl siloxane polymer, polydiethyl siloxane polymer and polymethylethyl siloxane polymer, and a polyalkyl aryl siloxane polymer, as well as a copolymer using plural species of silicon atom-containing monomer ingredients such as poly(dimethylsiloxane-diethyl siloxane), with the polydimethyl siloxane polymer being suitable.

In the polysiloxane polymer having two or more hydrogen atoms bonded to silicon atoms in the molecule thereof, a silicon atom to which an hydrogen atom is bonded may be either a silicon atom in the main chain or a silicon atom in the side chain. As the polysiloxane polymer having two or more hydrogen atoms bonded to silicon atoms in the molecule thereof, a polydimethyl hydrogen siloxane polymer such as poly(dimethyl siloxane-methylsiloxane) is suitable. Further, in the thermal addition reaction silicone release agent, a polysiloxane polymer having two or more hydrogen atoms bonded to silicon atoms in the molecule thereof has a function as a crosslinker.

The use amount of the polysiloxane polymer having two or more hydrogen atoms bonded to silicon atoms in the molecule thereof is not particularly restricted but can be properly selected depending on the curing property and the peeling strength of the film. Specifically, for sufficiently curing the film, the polysiloxane polymer having two or more hydrogen atoms bonded to the silicon atoms in the molecule is used preferably at such a ratio that the number of moles (may be referred to as "mol number $(X)$") of the silicon atoms to which the hydrogen atoms are bonded in the polysiloxane polymer having two or more hydrogen atoms bonded to the silicon atoms in the molecule thereof (that is, the silicon atom of Si-H bond) is larger than the number of moles (may be referred to as "mol number $(Y)$") of the alkenyl groups in the polysiloxane polymer having two or more alkenyl groups in the molecule thereof, and it is usually used at such a ratio that the mole number $(X)$/mol number $(Y)$ is within a range of 1.0 to 2.0, and preferably 1.2 to 1.6.

A catalyst can be used in a case of curing the polysiloxane polymer having two or more alkenyl groups in the molecule thereof by a polysiloxane polymer having two or more hydrogen atoms bonded to silicon atoms in the molecule thereof (crosslinker). As the catalyst, a platinum catalyst (for example, fine platinum particles, a platinum compound such as chloroplatinic acid or derivatives thereof) can be suitably used. While the use amount of the catalyst is not particularly restricted, it can be selected within a range, for example, from 0.1 to 1,000 ppm, and preferably from 1 to 100 ppm, based on the polysiloxane polymer having two or more alkenyl groups in the molecule thereof

The thermal addition reaction type silicone release agent can be prepared by mixing the constituent ingredients (such as a polysiloxane polymer having two or more alkenyl groups in the molecule thereof, a polysiloxane polymer having two or more hydrogen atoms bonded to silicon atoms in the molecule thereof, and optionally a catalyst or various kinds of additives) with optionally using an organic solvent. The thermal addition reaction type silicone release agent can be used in a state where the polymer ingredient such as the polysiloxane polymer is dissolved in an organic solvent. The thermal addition reaction type silicone release agent may also be properly blended with known or customary additives such as filler, antistatic, antioxidant, UV-ray absorbent, plasticizer, and colorant (dye or pigment).

As the thermal addition reaction type silicone release agent, "KS-847T" (trade name, manufactured by Shin-Etsu Chemical Co.); "KS-774" (trade name, manufactured by Shin-Etsu Chemical Co.); and "KS-841" (trade name, manufactured by Shin-Etsu Chemical Co.) are commercially available.

In the invention, since the silicone release agent is used as the release agent for the release liner, it is preferred in that the peeling strength with respect to an acrylic pressure-sensitive adhesive is low and the cost is also low. It is not preferable to use a fluorine or a long chained alkyl group release agent, since the peeling strength with respect to the acrylic pressure-sensitive adhesive is increased and the cost is also increased.

Liner substrate

The liner substrate used for the release liner of the invention is not particularly restricted and various types of substrates such as plastic substrates, paper substrates, and fiber substrates can be used. The liner substrate may have either a single layer or a plurality of laminate layers. The plastic substrate can be properly selected from various types of plastic substrates and used, and the examples thereof include polyolefin substrates such as polyethylene substrate, and polypropylene substrate, polyester substrates such as polyethylene terephthalate substrate, polyethylene naphthalate substrate, and polybutylene terephthalate substrate, polyamide type substrates (so-called "nylon" substrate), and cellulose substrates (so-called "cellophane" substrate). Further, the paper type substrate can be selected property from various kinds of paper substrates and used, and the examples thereof include Japanese paper, foreign paper, wood free paper, glassine paper, craft paper, culpack paper, crape paper, clay coat paper, synthesis paper, and paper formed by coating the surface of base paper with acrylic resin or polyvinyl alcohol resin (hereinafter referred to as "resin coated paper"). Among them, paper substrate is preferred, and glassine paper or resin coating paper is particularly preferred.

For the liner substrate described above, various types of surface treatments such as corona discharge treatment, or various kinds of surface fabrication such as embossing can be optionally applied to the surface thereof.

The thickness of the liner substrate is not particularly restricted but can be selected properly depending on the application use or the like and, generally, it can be selected from a range of 2 to 200 $\mu$m (preferably, from 25 to 150 $\mu$m).

The thickness of the release liner of the invention is, preferably, from 70 to 130 $\mu$m and, more preferably, from 80 to 120 $\mu$m.

The release liner of the invention can be manufactured by forming a releasing treatment layer containing a silicone release agent to the surface of the liner substrate. Specifically, examples of the method of manufacturing the release liner include a method including coating a thermosetting silicone release agent to the surface of a liner substrate by such a coating amount as providing a predetermined thickness after drying or curing, and drying or curing the same by heating thereby forming a releasing treatment layer; or a method including coating an ionizing radiation curable silicone release agent to the surface of a liner substrate by such a coating amount as providing a predetermined thickness after drying or curing, optionally drying the same by heating and then curing the same by the irradiation of ionizing irradiation ray (UV-rays, etc.) thereby forming a releasing treatment layer.

The method of heating upon drying or curing the thermosetting silicone release agent is not particularly restricted, and it can be properly selected from known heating methods (for example, a heating method of using an electric heater, a heating method of using electromagnetic waves such as infrared rays, etc.). Further, the method of irradiating ionizing radiation rays upon curing the ionizing radiation curable silicone release agent is not particularly restricted, and it can be properly selected from known irradiation methods of ionizing radiation rays (for example, UV-ray irradiation method using known UV-ray lamps such as high pressure mercury lamp having an electrode, ozone-less lamp, metal halide lamp, and microwave lamps with no electrode).

It is important that the release agent such as a thermosetting silicone release agent or ionizing radiation curable silicone release agent is coated in a proper coating amount on a substrate (substrate for use in release liner). When the coating amount of the release agent is insufficient, the peeling strength (force required for peeling) is increased to more than a desired peeling strength to result in a practical problem. On the other hand, when the amount thereof is excessive, the cost is increased to result in economical disadvantage, or it takes much time for curing to lower the productivity. While the appropriate coating amount of the release agent (solid content) can be selected properly in accordance with the kind of the pressure-sensitive adhesive, the kind of the liner substrate, or the kind of the silicone release agent to be used and it is, for example, about from 0.001 to 10 g/m$^2$, and preferably from 0.05 to 5 g/m$^2$.

In a case of coating the silicone release agent to the liner substrate, for example, known coating apparatus such as a direct gravure coater, an offset gravure coater, a roll coater, a bar coater, or a die coater can be properly selected and used.

In a case where the release liner of the invention has a releasing treatment layer (back surface treatment layer) also on the surface (back surface) opposite to the surface on which the releasing treatment layer formed by the silicone release agent is formed, the back surface treatment layer is also the same silicone release agent as described above.

Double-sided pressure-sensitive adhesive tape or sheet for use in wiring circuit board

The double-sided pressure-sensitive adhesive tape or sheet for use in wiring circuit board of the invention can be manufactured by providing the release liner(s) on one side or both sides of the adhesive portion described above. Specifically, examples of the method include (1) a method which includes disposing release liners on both sides of an adhesive portion having a substrate, (2) a method which includes disposing a release liner having releasing treatment layers on both sides thereof to one side of an adhesive portion having a substrate and protecting the other adhesive surface of the adhesive portion by winding the same into a roll form, (3) a method which includes forming a pressure-sensitive adhesive layer having no substrate on a releasing treatment surface of a release liner and further disposing another release liner on the other adhesive surface of the pressure-sensitive adhesive layer, and (4) a method including forming a pressure-sensitive adhesive layer having no substrate on a releasing treatment surface of a release liner having releasing treatment layers on both sides thereof and protecting the other adhesive surface of the pressure-sensitive adhesive layer by winding the same into a roll form.

In this invention, in the double-sided pressure-sensitive adhesive tape or sheet for use in wiring circuit board, the thickness from one adhesive surface to the other adhesive surface is preferably from 20 to 70 $\mu$m, more preferably from 30 to 60 $\mu$m, and particularly preferably from 40 to 60 $\mu$m. When the thickness from one adhesive surface to the other adhesive surface is less than 20 $\mu$m, good adhesiveness or bonding property cannot be obtained in some cases. On the other hand, when it exceeds 70 $\mu$m, since the thickness is excessive, this is not generally suitable as the double-sided pressure-sensitive adhesive tape or sheet for use in wiring circuit board.

In the double-sided pressure-sensitive adhesive tape or sheet for use in wiring circuit board of the invention, the peeling force between the adhesive portion and the release liner of the invention before the solder reflow step under the heat treatment conditions described above (hereinafter referred to as "peeling force in the initial stage") is preferably 0.3 to 1.5 (N/50 mm), and more preferably 0.5 to 1.2 (N/50 mm). When the peeling force in the initial stage is less than 0.3 (N/50 mm), the workability is sometimes lowered by the insufficiency of the adhesion strength. When it exceeds 1.5 (N/50 mm), the peeling force after the reflow step cannot sometime be controlled within a preferred range. Further, the peeling force between the pressure-sensitive adhesive and the release liner of the invention after the solder reflow step (hereinafter referred to as "peeling force after reflow step") is preferably from 0.3 to 3.0 (N/50 mm), and more preferably from 0.5 to 2.0 (N/50 mm). When the peeling force after the reflow step is less than 0.3 (N/50 mm), it sometimes results in a problem of lowering of the workability or "floating" of the release liner. When it exceeds 3.0 (N/50 mm), easy peeling is not sometimes possible and this may result in a problem of lowering of the workability and the productivity or destruction of the release liner upon peeling.

Wiring circuit board having double-sided pressure-sensitive adhesive tape

The wiring circuit board having a double-sided pressure-sensitive adhesive tape is obtained by adhering the double-sided pressure-sensitive adhesive tape or sheet for use in wiring circuit board of the invention on the back side of the wiring circuit board including at least an electric insulating layer (sometimes referred to as "base insulating layer") and an electric conductor layer (sometimes referred to as "conductor layer") formed on the base insulating layer so as to form a predetermined circuit pattern. That is the double-sided pressure-sensitive adhesive tape or sheet for use in wiring circuit board of the invention is adhered on the side of the base insulating layer which is opposite to the conductor layer side.

In the invention, in addition to the base insulating layer and the conductor layer formed so as to form a predetermined circuit pattern on the base insulating layer, the wiring circuit board may optionally have an electric insulating layer for coverage (sometimes referred to as "cover insulating layer") which is disposed on the conductor layer. Further, the wiring circuit board may also have a multi-layered structure in which a plurality of wiring circuit boards are laminated. The number of the wiring circuit boards (the number of layers in the multilayer) in the wiring circuit board of the multi-layered structure is not particularly restricted so long as they are two or more.

The wiring circuit board is not particularly restricted so long as it is a wiring circuit board and a flexible printing circuit board (FPC) is preferred. The wiring circuit board of the invention may be preferably used as a wiring circuit board to be used in various kinds of electronic equipments.

Base insulating layer

A base insulating layer is an electric insulator layer formed by an electric insulator. As the electric insulator for formation of a base insulating layer, there is no particular limitation and it can be appropriately selected from known electric insulators in wiring circuit board and used. Examples of the electric insulator include a plastic material such as polyimide resin, acrylate resin, polyether nitrile resin, polyether sulfone resin, polyester resin (such as polyethylene terephthalate resin and polyethylene naphthalate resin), polyvinyl chloride resin, polyphenylene sulfide resin, polyether ketone resin, polyamide resin (such as the so-called "aramid resin"), polyallylate resin, polycarbonate resin and liquid crystal polymer; a ceramic material such as alumina, zirconia, soda glass and quartz glass; and various kinds of compounded materials having electric insulating property (non-conductive property). Each of electric insulators may be used solely or two or more thereof may be used in combination. Among them, as the electric insulator, a plastic material (particularly a polyimide resin) is advantageous. Accordingly, a base insulating layer is preferred to be formed by a plastic film or sheet (particularly, film or sheet which is prepared by a polyimide resin). As the electric insulator, an electric insulator having photosensitivity (e.g., a photosensitive plastic material such as photosensitive polyimide resin) may also be used.

A base insulating layer may be in any form of single layer and layered product. Surface of the base insulating layer may be subjected to various kinds of surface treatment (such as corona discharge treatment, plasma treatment, surface-roughening treatment and hydrolyzing treatment). Although there is no particular limitation for thickness of the base insulating layer, it may be appropriately selected within the range of, for example, 3 to 100 $\mu$m (preferably 5 to 50 $\mu$m, and more preferably 10 to 30 $\mu$m).

Conductor layer

A conductor layer is an electric conductor layer formed by an electrically conductive material. The conductor layer is formed on the above-mentioned base insulating layer so as to form a predetermined circuit pattern. As the electrically conductor material for the formation of such a conductor layer, there is no particular limitation and appropriate one may be selected from the electrically conductive materials used for known wiring circuit boards and is used. Specific examples of the electrically conductive material include various kinds of alloy (such as solder), metal material such as platinum and an electrically conductive plastic material in addition to copper, nickel, gold and chromium. Each electrically conductive material may be used solely or two or more thereof may be used in combination. In the present invention, a metal material (particularly copper) is suitable as an electrically conductive material.

A conductor layer may be in any form of single layer and layered product. Surface of the conductor layer may be subjected to various kinds of surface treatment.

Although there is no particular limitation for thickness of the conductor layer, it may be appropriately selected within, for example, a range of 1 to 50 $\mu$m (preferably 2 to 30 $\mu$m, and more preferably 3 to 20 $\mu$m).

With regard to a method for the formation of a conductor layer, there is no particular limitation but it may be appropriately selected from known methods for the formation thereof (known patterning method such as a subtractive method, an additive method and a semi-additive method). When, for example, a conductor layer is directly formed on the surface of a base insulating layer, a conductor layer can be formed by plating or vapor deposition of a conductor material on a base insulating layer utilizing a non-electrolytic plating method, an electrolytic plating method, a vacuum vapor deposition method, a sputtering method, and the like so as to give a predetermined circuit pattern.

Cover insulating layer

A cover insulating layer is an electric insulator layer for covering (electric insulator layer for protection) which is formed by an electric insulating material and covers the conductor layer. A cover insulating layer is disposed according to the necessity and is not necessary to be disposed at all times. As the electrically insulating material for the formation of a cover insulating material, there is no particular limitation but, the same as in the case of a base insulating layer, it may be appropriately selected from electrically insulating materials used in known wiring circuit boards and is used. To be more specific, As the electrically insulating material for the formation of a cover insulating layer, examples thereof include the electrically insulating material which are exemplified as an electrically insulating material for the formation of the above base insulating layer and, the same as in the case of a base insulating layer, a plastic material (particularly a polyimide resin) is advantageous. Each electrically insulating material for the formation of a cover insulating layer may be used solely or two or more thereof may be used in combination.

A cover insulating layer may be in any of the forms of single layer and layered product. Surface of the cover insulating layer may be subjected to various kinds of surface treatment (such as corona discharge treatment, plasma treatment, treatment for making the surface rough and hydrolyzing treatment).

With regard to thickness of a cover insulating layer, there is no particular limitation but it may be appropriately selected within, for example, a range of 3 to 100 $\mu$m (preferably 5 to 50 $\mu$m, and more preferably 10 to 30 $\mu$m).

The method of forming the cover insulating layer is not particularly restricted but may be properly selected from known forming methods (such as a method of coating and drying a liquid material or a molten material containing the electric insulator or a method of laminating a film or sheet which corresponds to the shape of the conductor layer and is formed of an electric insulator).

The wiring circuit board having the double-sided pressure-sensitive adhesive tape of the present invention may be used, for example, by being fixed to a support such as a reinforcing plate by utilizing a double-sided pressure-sensitive adhesive tape or sheet for use in the wiring circuit board adhered on the back side thereof. Such a reinforcing plate is usually disposed on the side (back side) of the base insulting layer opposite to the conductor layer side. The reinforcing material for forming the reinforcing plate is not particularly restricted but may be properly selected from known reinforcing plate materials for forming the reinforcing plate and used. The reinforcing plate material may have conductivity or non-conductivity. The reinforcing plate material includes, for example, a metal material such as stainless steel, aluminum, copper, iron, gold, silver, nickel, titanium and chromium; a plastic material such as polyimide resin, acrylate resin, polyether nitrile resin, polyether sulfone resin, polyester resin (such as polyethylene terephthalate resin and polyethylene naphthalate resin), polyvinyl chloride resin, polyphenylene sulfide resin, polyether ether ketone resin, polyamide resin (such as a so-called "aramid resin"), polyallylate resin, polycarbonate resin, epoxy resin, glass epoxy resin and liquid polymer; and inorganic material such as alumina, zirconia, soda glass, quartz glass, and carbon. As the reinforcing plate material, a metal material such as stainless steel and aluminum and a plastic material such as polyimide resin are preferred and, among them, stainless steel and aluminum can be used particularly preferably. Accordingly, it is preferred that the reinforcing plate is formed of a metal foil or a metal plate (such as stainless steel foil or stainless steel plate and aluminum foil or aluminum plate) or a plastic film or sheet (such as film or sheet made of polyimide resin). The reinforcing material may be used alone or two or more of them in combination. The reinforcing plate may be either of a monolayer or of a lamination form the surface of the reinforcing plate may be applied with various kinds of surface treatments. The thickness of the reinforcing plate is not particularly restricted but may be properly selected, for example, within a range of 50 to 2,000 $\mu$m (preferably 100 to 1,000 $\mu$m).

Examples

The present invention is to be described specifically by way of examples, but the invention is not limited to the examples.

Example 1

90 parts by weight of 2-ethylhexyl acrylate and 10 parts by weight of acrylic acid were subjected to a solution polymerization treatment in 210 parts of ethyl acetate in the presence of 0.4 parts by weight of 2,2'-azobisisobutyronitrile while stirring at 60 to 80°C under nitrogen substitution to prepare a pressure-sensitive adhesive solution containing an acrylic polymer (viscosity: about 120 poise; degree of polymerization: 99.2%; solids: 30.0% by weight).

To 100 parts by weight of the acrylic polymer, were added 20 parts of terpene phenol tackifier resin ("YS Polyste S 145" (trade name) manufactured by Yasuhara Chemical Co., Ltd.; softening point: 145°C) and 0.05 part by weight of a multifunctional epoxy crosslinker (trade name: "Tetrad C"; manufactured by Mitsubishi Gas Chemical Company, Inc.), followed by mixing to obtain a pressure-sensitive adhesive composition.

A releasing treatment layer prepared by blending one part by weight of a UV-ray fragmentation initiator "CAT-7605" (manufactured by Shin-Etsu Chemical Co.) blended based on 100 parts by weight of a silicone releasing treatment agent (cationically polymerizable LTV-ray curable silicone release agent "X-62-7658" manufactured by Shin-Etsu Chemical Co.) and adjusting the solid concentration to 1.0 wt% with heptane) was disposed on a surface of glassine paper "NSGP-RT100" (manufactured by Oji Specialty Paper Co. Ltd.) to manufacture a release liner (coating amount (solid content) : 2.5 g/m$^2$). The releasing treatment layer was formed by coating, drying, and UV-ray curing.

After coating the pressure-sensitive adhesive composition described above on the surface of the release liner (surface of the releasing treatment layer), it was applied with a drying treatment at 130°C for 5 min to form a pressure-sensitive adhesive layer of 20 $\mu$m thickness. Then, after adhering a non-woven fabric of Manila hemp (thickness: 18 $\mu$m) on the pressure-sensitive adhesive layer and subsequently coating the pressure-sensitive adhesive composition on the surface of the non-woven fabric, it was applied with a drying treatment at 130°C for 5 min to form another pressure-sensitive adhesive layer to obtain a double-sided pressure-sensitive adhesive sheet having a thickness of 50 $\mu$m from the adhesive surface of one pressure-sensitive adhesive layer to the adhesive surface of the other pressure-sensitive adhesive layer.

Examples 2 to 4

Double-sided pressure-sensitive adhesive sheets were obtained quite in the same manner as in Example 1 except for changing the addition amount of the terpene phenol tackifier resin "YS polyster S 145" as shown in Table 1.

Example 5

A pressure-sensitive adhesive composition was obtained quite in the same manner as in Example 1 except for changing the blending amount of the crosslinker as shown in Table 1.

Then, after coating the pressure-sensitive adhesive composition on the surface of the same release liner (surface of the releasing treatment layer) as in Example 1, it was applied with a drying treatment at 130°C for 5 min to form a pressure-sensitive adhesive layer of 50 μm thickness thereby obtaining a double-sided pressure-sensitive adhesive sheet including an adhesive portion having no substrate.

Example 6

A double-sided pressure-sensitive adhesive sheet including an adhesive portion having no substrate was obtained quite in the same manner as in Example 5 except for changing the tackifier resin to the alkyl phenol tackifier resin as shown in Table 1.

Comparative Examples 1 and 2

As shown in Table 1, pressure-sensitive adhesive compositions were obtained quite in the same manner as in Example 1 except that the terpene phenol tackifier resin "YS polyster S 145" was not used. In Comparative Example 2, the addition amount of the crosslinker was further changed. Further, a double-sided pressure-sensitive adhesive sheet including an adhesive portion having no substrate was obtained in the same manner as in Example 5.

Comparative Examples 3 and 4

As shown in Table 1, pressure-sensitive adhesive compositions were obtained quite in the same manner as in Example 1 except for changing the tackifier resin to a resin having no phenolic hydroxyl group. Further, a double-sided pressure-sensitive adhesive sheet including an adhesive portion having no substrate was obtained in the same manner as Example 5.

Evaluation

The double-sided pressure-sensitive adhesive tapes or sheets obtained by Examples 1 to 6 and Comparative Examples 1 to 4 were measured or evaluated by the following measuring method or evaluation method. The results of measurement or evaluation are shown in Table 1. For the heat treatment conditions in the solder reflow step, the conditions described above were used and the step was conducted in accordance with the temperature profile where the peak temperature was present at about 250°C as shown in Fig. 5.

Peeling force

Rectangular samples each having 50 mm width and 100 mm length were manufactured from the double-sided pressure-sensitive adhesive sheets obtained in the Examples and the Comparative Examples.
By using a tensile tester, 180° peeling test was carried out according to JIS Z 0237 to measure a 180° peel strength (N/50 mm) of the release liner. The measurement was carried out after aging the sample for 30 min under the conditions at a temperature of 23°C and at a relative humidity of 65%, under the conditions at a peeling angle of 180° and at a tensile speed of 300 mm/min in an atmosphere at a temperature of 23°C and at a relative humidity of 65%.
For the samples applied with the heat treatment under the heat treatment conditions in the solder reflow step described above and for the samples without being applied with such treatment, 180° peel strength were respectively determined and the former was defined as the peeling force after the reflow step and the latter was defined as the peeling force at the initial stage.

Table 1

| | | | Example 1 | Example 2 | Example 3 | Example 4 | Example 5 | Example 6 |
|---|---|---|---|---|---|---|---|---|
| Adhesive portion | Acrylic polymer | Blending amount (ppw) | 100 | 100 | 100 | 100 | 100 | 100 |
| | Tackifier resin | Kind | Terpenephenol type | Terpenephenol type | Terpenephenol type | Terpenephenol type | Terpenephenol type | Alkylphenol type |
| | | Product name | YS polyster S145 | YS polyster S145 | YS polyster S145 | YS polyster S145 | YS polyster S145 | Sumilite 19900 |
| | | Manufacturer's name | Yasuhara Chemical Co. | Yasuhara Chemical Co. | Yasuhara Chemical Co. | Yasuhara Chemical Co. | Yasuhara Chemical Co. | Sumitomo Bakelite Co. |
| | | Blending amount (ppw) | 20 | 15 | 10 | 5 | 20 | 20 |
| | Crosslinker | Blending amount (ppw) | 0.05 | 0.05 | 0.05 | 0.05 | 0.175 | 0.175 |
| | Substrate | | Non-woven fabric | Non-woven fabric | Non-woven fabric | Non-woven fabric | None | None |
| Release liner | Release agent | | UV-curable type silicone | UV-curable type silicone | UV-curable type silicone | UV-curable type silicone | UV-curable type silicone | UV-curable type silicone |
| | Release liner | | Glassine paper | Glassine paper | Glassine paper | Glassine paper | Glassine paper | Glassine paper |
| | Basis weight (g/m$^2$) | | 100 | 100 | 100 | 100 | 100 | 100 |
| Peeling force (N/50 mm) | Initial stage | | 0.9 | 1.1 | 1.2 | 1.5 | 0.9 | 0.7 |
| | After reflow step | | 1.3 | 1.7 | 2.0 | 2.8 | 1.5 | 1.6 |

EP 1 980 601 A2

Table 1 (continued)

| | | | Comparative Example 1 | Comparative Example 2 | Comparative Example 3 | Comparative Example 4 |
|---|---|---|---|---|---|---|
| Adhesive portion | Acrylic polymer | Blending amount (ppw) | 100 | 100 | 100 | 100 |
| | Tackifier resin | Kind | - | - | Rosin ester type | Terpene type hydrogenated resin |
| | | Product name | - | - | Ester gum 105 | CLEARON P150 |
| | | Manufacturer's name | - | - | Arakawa Chemical Industry Co. | Yasuhara Chemical Co. |
| | | Blending amount (ppw) | 0 | 0 | 20 | 20 |
| | Crosslinker | Blending amount (ppw) | 0.05 | 0.03 | 0.05 | 0.05 |
| | Substrate | | None | None | None | None |
| Release liner | Release agent | | UV-curable type silicone | UV-curable type silicone | UV-curable type silicone | UV-curable type silicone |
| | Release liner | | Glassine paper | Glassine paper | Glassine paper | Glassine paper |
| | Basis weight (g/m²) | | 100 | 100 | 100 | 100 |
| Peeling force (N/50 mm) | | Initial stage | 1.7 | 1.9 | 0.7 | 0.8 |
| | | After reflow step | 4.0 | 3.8 | 3.3 | 3.1 |

From Table 1, it was confirmed that the releasability of the release liners was maintained in double-sided pressure-sensitive tapes or sheets of the invention (Examples 1 to 6) even after the solder reflow step and they can be suitably used as the double-sided tapes or sheets for use in wiring circuit board.

While the present invention has been described in detail and with reference to specific embodiments thereof, it will be apparent to one skilled in the art that various changes and modifications can be made therein without departing from the scope thereof.

This application is based on Japanese patent application No. 2007-101919 filed on April 9, 2007, the entire contents thereof being hereby incorporated by reference.

Further, all references cited herein are incorporated in their entireties.

**Claims**

1. A double-sided pressure-sensitive adhesive tape or sheet for use in a wiring circuit board, which comprises:

   a pressure-sensitive adhesive layer formed of a pressure-sensitive adhesive composition comprising an acrylic polymer and a tackifier resin containing a phenolic hydroxyl group; and
   a release liner comprising a releasing treatment layer formed of a silicone release agent.

2. A double-sided pressure-sensitive adhesive tape or sheet for use in a wiring circuit board, which comprises:

   a substrate;
   a plurality of pressure-sensitive adhesive layers formed on both sides of the substrate, wherein at least one of said plurality of pressure-sensitive adhesive layers is a pressure-sensitive adhesive layer formed of a pressure-sensitive adhesive composition comprising an acrylic polymer and a tackifier resin containing a phenolic hydroxyl group; and
   a release liner comprising a releasing treatment layer formed of a silicone release agent.

3. The double-sided pressure-sensitive adhesive tape or sheet according to claim 1, wherein the tackfier resin containing a phenolic hydroxyl group is at least one member selected from the group consisting of a phenol-modified terpenic tackifier resin, a phenol-modified rosinic tackifier resin and a phenolic tackifier resin.

4. The double-sided pressure-sensitive adhesive tape or sheet according to claim 2, wherein the tackfier resin containing a phenolic hydroxyl group is at least one member selected from the group consisting of a phenol-modified terpenic tackifier resin, a phenol-modified rosinic tackifier resin and a phenolic tackifier resin.

5. The double-sided pressure-sensitive adhesive tape or sheet according to claim 1, wherein the pressure-sensitive adhesive composition contains the tackifier resin containing a phenolic hydroxyl group at a ratio of from 1 to 45 parts by weight based on 100 parts by weight of the acrylic polymer.

6. The double-sided pressure-sensitive adhesive tape or sheet according to claim 2, wherein the pressure-sensitive adhesive composition contains the tackifier resin containing a phenolic hydroxyl group at a ratio of from 1 to 45 parts by weight based on 100 parts by weight of the acrylic polymer.

7. A double-sided pressure-sensitive adhesive tape or sheet according to claim 2, wherein the substrate comprises a non-woven fabric.

8. The double-sided pressure-sensitive adhesive tape or sheet according to claim 1, which has a thickness from one adhesive surface to the other adhesive surface of from 20 to 70 $\mu$m.

9. The double-sided pressure-sensitive adhesive tape or sheet according to claim 2, which has a thickness from one adhesive surface to the other adhesive surface of from 20 to 70 $\mu$m.

10. The double-sided pressure-sensitive adhesive tape or sheet according to claim 1, wherein the silicone release agent is a UV-ray curable silicone release agent.

11. The double-sided pressure-sensitive adhesive tape or sheet according to claim 2, wherein the silicone release agent is a UV-ray curable silicone release agent.

12. A wiring circuit board comprising an electric insulator layer and an electric conductor layer formed on the electric insulator layer so as to form a predetermined circuit pattern, wherein the double-sided pressure-sensitive adhesive tape or sheet according to claim 1 is adhered on the back side of the wiring circuit board.

**13.** A wiring circuit board comprising an electric insulator layer and an electric conductor layer formed on the electric insulator layer so as to form a predetermined circuit pattern, wherein the double-sided pressure-sensitive adhesive tape or sheet according to claim 2 is adhered on the back side of the wiring circuit board.

## FIG. 1

## FIG. 2

## FIG. 3

## FIG. 4

## FIG. 5

IR REFLOW TEMP. PROFILE

Legend:
- PEAK AT 250 DEG. C
- PEAK AT 260 DEG. C
- PEAK AT 270 DEG. C

Y-axis: TEMPERATURE [DEG. C] (0, 50, 100, 150, 200, 250, 300)
X-axis: TIME [SEC.] (0, 50, 100, 150, 200, 250, 300, 350, 400)

**EP 1 980 601 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001040301 A
- JP 6032873 A
- JP 2000281965 A
- JP 11228702 A
- JP 8026120 B
- JP 2007101919 A